Europäisches Patentamt

(19) European Patent Office

Office européen des brevets

(11) Publication number : **0 413 546 B1**

(12) **EUROPEAN PATENT SPECIFICATION**

(45) Date of publication of patent specification :
**22.11.95 Bulletin 95/47**

(51) Int. Cl.⁶ : **H01L 21/205,** H01L 21/20,
H01L 21/365

(21) Application number : **90308907.6**

(22) Date of filing : **14.08.90**

(54) Method of forming compound semiconductor layer.

(30) Priority : **17.08.89 JP 210650/89**

(43) Date of publication of application :
**20.02.91 Bulletin 91/08**

(45) Publication of the grant of the patent :
**22.11.95 Bulletin 95/47**

(84) Designated Contracting States :
**DE FR GB**

(56) References cited :
**WO-A-89/04549**
**US-A- 4 632 712**
**APPLIED PHYSICS LETTERS, vol. 51, no. 1, 6th
July 1987, pages 36-38, American Institute of
Physics, New York, NY, US; R.M. LUM et al.:
"Improvements in the heteroepitaxy of GaAs
on Si"**

(56) References cited :
**JAPANESE JOURNAL OF APPLIED PHYSI-
CS/PART 2: LETTERS, vol. 26, no. 12, Decem-
ber1987, pages L1950-L1952, Tokyo, JP; H.
OKAMOTO et al.: "Dislocation reduction in
GaAs on Si by thermal cycles and In-
GaAs/GaAs strained-layer superlattices"
SOLID STATE TECHNOLOGY, November 1987,
pages 91-97**

(73) Proprietor : **FUJITSU LIMITED
1015, Kamikodanaka,
Nakahara-ku
Kawasaki-shi, Kanagawa 211 (JP)**

(72) Inventor : **Eshita, Takashi
6-19 Omori Nishi 1-chome
Ota-ku, Tokyo 143 (JP)**
Inventor : **Inoue, Toshikazu
Joyful Okura 20-406,
381-1 Morookamachi,
Kohoku-ku
Yokohama-shi, Kanagawa 222 (JP)**

(74) Representative : **Rackham, Stephen Neil et al
GILL JENNINGS & EVERY,
Broadgate House,
7 Eldon Street
London EC2M 7LH (GB)**

## Description

The present invention relates to a hetero-epitaxial growth of a compound semiconductor layer on a silicon (Si) single crystalline substrate, and more particularly, to a method of forming a gallium arsenide (GaAs) thin layer on the Si substrate. The present invention is applied to a compound semiconductor/Si (e.g., GaAs/Si) substrate for compound semiconductor (GaAs) devices.

A compound semiconductor substrate, for example, a GaAs substrate is produced by growing a single crystal (GaAs) lump (ingot) by a pulling method (Czochralski method) or the like, and then cutting (slicing) the lump into substrates (wafers). Such a GaAs substrate is expensive, easily broken, and has a relatively small size.

Recently, the degree of integration of a GaAs IC (integrated circuit) and a chip size (area) thereof have been increased, leading to a demand for a larger size and a strong, not easily broken GaAs substrate. As such a large wafer size GaAs substrate, a GaAs/Si substrate produced by a hetero-epitaxial growth of a GaAs thin layer on a Si substrate has been proposed, and during this growth, GaAs layer GaAs devices such as high-speed transistors and photo-emitting elements (e.g., lasers, LED's) are formed (see, for example, Kaminishi and Akiyama: "GaAs layer is directly grown on a Si wafer and devices are formed on the layer", Nikkei-Microdevices, No. 7, January, 1986, pp. 113-127).

A metalorganic chemical vapor deposition (MOCVD) method and a molecular beam epitaxy (MBE) method have been used for growing a hetero-epitaxil GaAs layer on a Si substrate. Further, for the growth (formation) of the GaAs layer, a two step growth method consisting of a first step of growing a noncrystalline (amorphous or partially crystallized) GaAs thin layer on a Si substrate at a relatively low temperature, and a second step of epitaxially growing GaAs thereon at a high temperature to obtain a predetermined layer thickness, has been proposed.

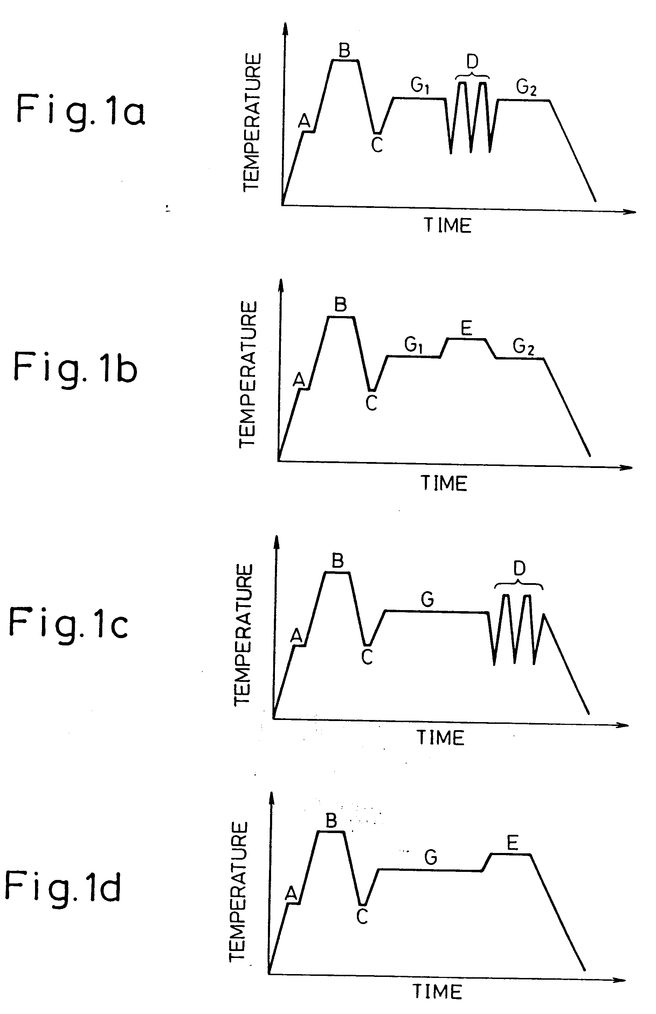

Such a formed GaAs layer has crystal defects such as dislocation, and therefore, the substrate with the GaAs layer must be subjected to a heat treatment (annealing), to reduce the dislocations, under an atmosphere comprising hydrogen ($H_2$) gas and arsenic (As) gas (or arsine ($AsH_3$) gas). Such a process is described in the description with respect to Figure 1 below.

Conventionally when the heat treatment for reducing the dislocation density is performed, however, the (exposed) surface layer portion of the grown GaAs layer becomes n-type, due to an unintentional n-type impurity (e.g., Si) doping to that portion, and accordingly, a leakage current is liable to flow through the n-type portion of the GaAs layer (GaAs/Si substrate) to the silicon substrate and the doping control can not be satisfactorily performed.

To prevent or reduce the leakage current, there is an attempt to additionally form a high (electric) resistance layer within the epitaxial GaAs layer. In this case, the high resistance layer is formed by epitaxially growing GaAs with doping an impurity (Cr, Fe or V). However, such impurities contaminate a reactor (growing furnace) and remain therein to have an undesirable influence on the GaAs layer portion grown at a later stage.

According to the present invention there is provided a method of forming a compound semiconductor layer hetero-epitaxially grown on a silicon single crystal substrate comprising the steps of:

growing a first compound semiconductor layer on said silicon substrate;

heat treating said substrate; and

growing a second compound semiconductor layer on said first compound semiconductor layer characterised by doping the interface between the first compound semiconductor layer and the second compound semiconductor layer with a p-type impurity prior to or during the step of growing the second compound layer.

The present invention provides a method of preventing an increase of the electron carrier concentration of the portion of the grown GaAs layer, caused by the heat treatment for reducing the dislocation density, to thereby reduce the leakage current and enable a desired doping control during the fabrication of the device. The method is suitable for producing a compound semiconductor device or element by using the compound semiconductor layer formed on a Si substrate without generating the increased electron carrier concentration portion.

Preferably the p-type impurities (Zn, Be, C, or Mg) are doped (thermally diffused) into the first (III-V group compound semiconductor layer during the heat treatment for reducing the dislocation density, to compensate for the increase of the electron carriers. Namely, the doping amount is corresponded to the amount of electron carriers, to make the carrier concentration at an interface between the first and second compound semiconductor layers $10^{-6}$ cm$^{-3}$ or less.

The impurity-doping by can be carried out by an ion-implantation method instead of the thermal diffusion method, before or after the heat treatment for reducing the dislocation density. In this case, an annealing treatment must be carried out, to recover the ion-implanted portion and activated the p-type impurities, at a suitable stage.

Preferably the III-V group compound semiconductor layer is GaAs, AlAs, GaP, InAs, and a mixture thereof (in particular, GaAs). It is possible to use II-VI group compound (ZnSe, ZnS, and HgCdTe), and IV-VI group compound (SnTe, PbS, and PbSe), as the compound semiconductor layer other than the III-V group compound.

BRIEF DESCRIPTION OF THE DRAWINGS

The present invention will be more apparent from the description of the preferred embodiments set forth below, with reference to the accompanying drawings, in which:

Figs. 1A to 1D are graphs of temperature profiles during the formation of the GaAs layer on a Si substrate;

Fig. 2 is a schematic sectional view of a GaAs/Si substrate;

Fig. 3 is a graph, similar to Fig. 1A, of a temperature profile for the growth of the GaAs layer of a GaAs/Si substrate according to the present invention;

Fig. 4 is a graph showing a carrier concentration distribution in a GaAs/Si substrate having the GaAs layer in accordance with the temperature profile of Fig. 2, in a thickness direction; and

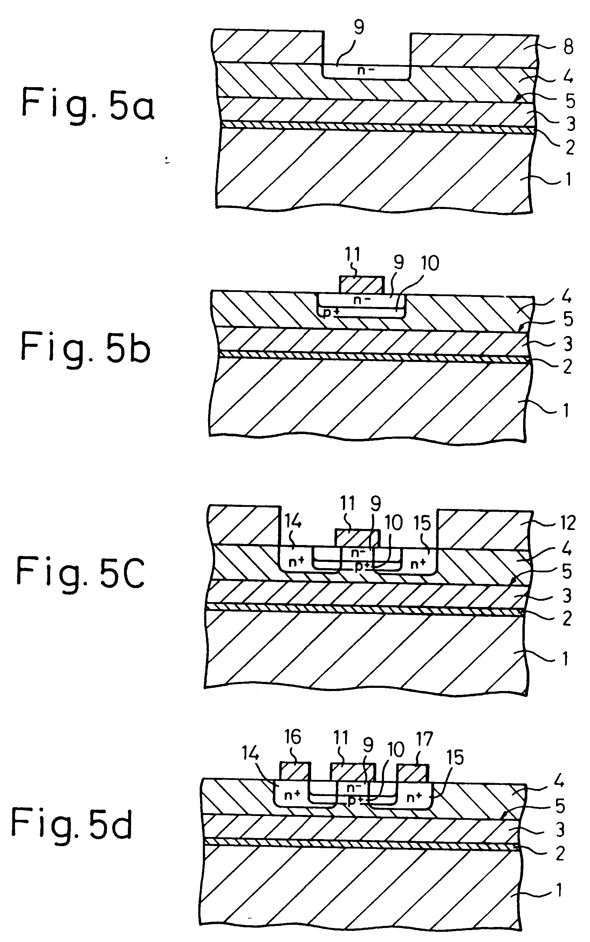

Figs 5a to 5d are schematic sectional views of a GaAs device in various stages of the production thereof, using the GaAs/Si substrate. Conventionally heat treatment is performed in accordance with one of the temperature profiles shown in Fig. 1A to 1D. As shown in these drawings, first a Si substrate is preheated at step A, is heated at a high temperature for surface-cleaning at step B, is covered with a noncrystalline (amorphous) GaAs thin layer grown thereon at a relatively low temperature (e.g., 450°C) at step C, and is further covered with an epitaxial GaAs layer grown on the amorphous layer at a high temperature (e.g., 700°C). in Figs. 1A and 1B, the growth of the epitaxial GaAs layer is performed twice at steps $G_1$ and $G_2$ , and between the steps $G_1$ and $G_2$ the heat treatment for reducing the dislocation density is carried out by a thermal cycle treatment (at step D in Fig. 1A, at least one cycle of heating the substrate to a temperature higher than a growth temperature of the GaAs layer and cooling the substrate to a temperature lower than the growth temperature is carried out) or by a high temperature annealing treatment (at step E in Fig. 1B, wherein the substrate is held at a temperature higher than the growth temperature). In Figs. 1C and 1D, after the growth of the GaAs layer (at step G) the heat treatment for reducing the dislocation density is carried out by the thermal cycle treatment (at step D in Fig. 1C) or by the high temperature annealing treatment(at step E in Fig. 1D).

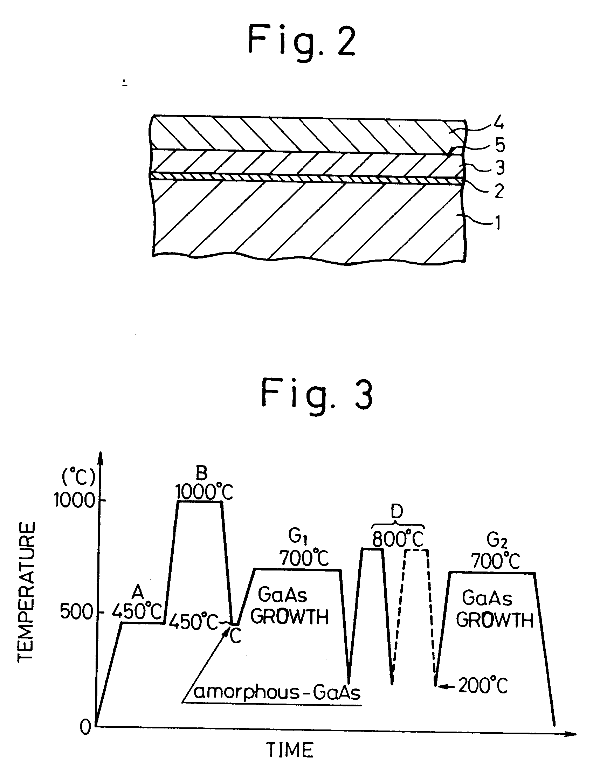

Referring to Figs. 2 and 3, compound semiconductor (for example, GaAs) layer is formed (hetero-epitaxially grown) on a Si substrate, i.e., a GaAs/Si substrate is produced in accordance with a first embodiment of the present invention.

First, a Si substrate (single crystal wafer) 1 is set in a conventional growing reactor or furnace (not shown). The furnace is evacuated, to obtain a high vacuum pressure, and the Si substrate is preheated at 450°C (step A). Then an $H_2$ gas (12 SLM) and an $AsH_3$ gas (100 sccm) are fed into the furnace to bring the inside pressure to 76 Torr (10kPa), and the substrate temperature is raised to 1000°C and held thereat for 10 minutes, to clean the surface of the Si substrate (step B).

Next, the substrate temperature is lowered to 450°C, and a $Ga(CH_3)_3$ gas (24 sccm) is additionally fed into the furnace, and the $H_2$ gas (at 12 SLM) and $AsH_3$ gas (increased to 200 sccm) are continuously fed into the furnace, thereby grow (deposit) a noncrystalline (amorphous) GaAs thin layer 2 having a thickness of about 10 nm on the Si substrate 1 (step C), as shown in Fig. 2. Thereafter, the substrate temperature is raised to 700°C, and the $H_2$ gas (constant at 12 SLM), the $AsH_3$ gas (increased to 200 sccm), and the $Ga(CH_3)_3$ gas (increased to 29 sccm) are continuously fed into the furnace, to epitaxially grow a first GaAs layer 3 having a thickness of from 1 to 3 $\mu$m (e.g., about 1.3 $\mu$m) on the amorphous GaAs layer 2 (step $G_1$).

The GaAs growth is interrupted by a heat treatment for reducing the dislocation density. This thermal cycle treatment and consists of one to 20 cycles (in this case, 5 cycles) of cooling to 200°C and heating to 800°C (step D), as shown in Fig. 3. During the heat treatment in a conventional case, the atmosphere is composed of the $H_2$ gas (constant at 12 SLM) and the $AsH_3$ gas (reduced to 120 sccm), by stopping the feed of the $Ga(CH_3)_3$ gas. According to the present invention, a p-type impurity containing gas, e.g., $Zn(C_2H_5)_2$ gas (0.5 to 30 sccm) is additionally fed, together with the $H_2$ gas and the $AsH_3$ gas, into the reactor to form an atmosphere, and accordingly, when the Si substrate 1 with the GaAs layer 3 is heated at 800°C, Zn (p-type impurity) is thermally diffused into the GaAs layer 3, i.e., the GaAs layer 3 is doped with the Zn. The $AsH_3$ gas, as a V group source gas, is continuously fed for a period other than the GaAs growth time, whereby a vaporization of As, which has a high vapor pressure and is easily vaporized, is prevented.

It is possible to adopt an $As(CH_3)_3$ gas for carbon (C) impurities or an $Mg(C_5H_5)_2$ or for $Mg(C_5H_3C_5H_4)_2$ gas for Mg impurities, instead of the $Zn(C_2H_5)_2$ gas.

After the heat treatment, the substrate temperature is raised to 700°C and the epitaxial growth of GaAs is repeated by feeding the $H_2$ gas (12 SLM), the $AsH_3$ gas (200 sccm), and $Ga(CH_3)_3$ gas (29 sccm, in the same way as in step $G_1$ , into the growing reactor to form a second GaAs layer 4 having a thickness of from 1 to 10 µm (e.g., about 1.9 µm) on the first GaAs layer 3 (step $G_2$). Accordingly, a GaAs/Si substrate is produced, and the obtained GaAs epitaxial layer of the substrate consists essentially of the first and second GaAs layers 3 and 4 having an interface 5 therebetween, and has thickness of, e.g., about 3.2 µm.

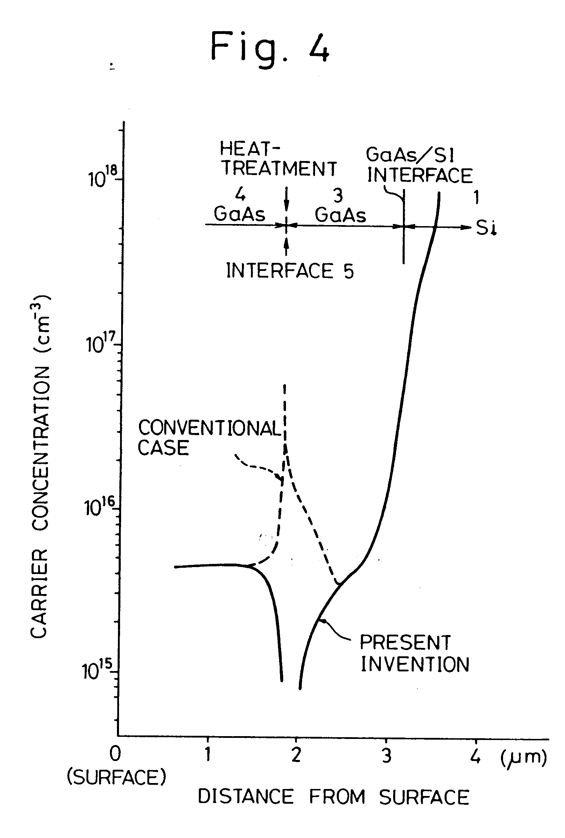

The (electron) carrier concentration of the obtained GsAs/Si substrate, from the top surface thereof in a layer thickness direction, is determined and the result shown in Fig. 4 obtained. As shown in Fig. 4, where a conventional heat treatment for reducing the dislocation density is performed in a thermal cycle treatment mode, the electron carrier concentration is increased at the interface 5 between the first and second epitaxial layer 3 and 4 (indicated with a broken line) at which the heat treatment is carried out, to form an n-type portion. On the other hand, in accordance with the present invention, the p-type impurity (such as Zn) doping is carried out during the heat treatment, and thus the carrier concentration becomes lower than the measuring range of the measuring equipment employed, as indicated by a solid line. Namely, the electron carriers in the portions of the first and second GaAs layers 3 and 4 near the interface 5 are compensated by the p-type dopants (impurities), and thus the carrier concentration at and near the interface 5 is lowered to $4.5 \times 10^{15}$ cm$^{-3}$ or less (lower than the carrier concentration in the second epitaxial GaAs layer 4). The desired doping control can be carried out when the carrier concentration becomes $1 \times 10^{16}$ cm$^{-3}$. Therefore, according to the present invention, it is possible to prevent the increase of the electron carrier concentration caused by a conventional heat treatment for reducing the dislocation density, at and near the interface in the GaAs layer formed on the Si substrate, to thereby obtain a GaAs/Si substrate having a leakage current lower than that of conventional GaAs/Si substrates.

The heat treatment for reducing the dislocation density can be performed by holding the Si substrate with the first epitaxial GaAs layer 3 at a constant high temperature, e.g., 800°C, instead of the thermal cycle treatment, and in this case, the temperature profile is similar to that of Fig. 1B. The atmosphere of the heat treatment is composed of the $H_2$ gas, the $AsH_3$ gas, and the $Zn(C_2H_5)_2$ gas (the p-type impurity containing gas) added in accordance with the present invention, and during the heat treatment the Zn (p-type impurity) is thermally diffused into the first epitaxial GaAs layer 3, to prevent the formation of the n-type portion as explained above.

It is possible to adopt other III-V group compound semiconductor materials, such as AlAs, GaP and InAs, for the first epitaxial GaAs layer 3, instead of the above-mentioned GaAs. It is also possible to adopt other III-V group compound semiconductor materials (such as AlAs, GaP and InAs), II-VI group compound materials (such as ZnSe, ZnS and HgCdTe), or IV-VI group compound materials (SnTe, Pbs, and PbSe) for the second epitaxial GaAs layer 4 instead of the above-mentioned GaAs.

An ion-implantation method can be used for doping the first epitaxial GaAs layer 3 with the p-type impurities, instead of the above-mentioned thermal diffusion method, but in this case, after the ion-implantation treatment, the ion-implanted GaAs layer 3 (i.e., the Si substrate) must be subjected to an annealing process (additional heat treatment), to recover the ion-implanted portion and activate the implanted p-type impurities. The following ion-implantation conditions are preferable:

| Ion-implanted Element | Implanting Energy (keV) | Dose amount (cm$^{-2}$) |
|---|---|---|
| 1.   Mg$^+$ | 10 - 50 | $10^{11}$ - $10^{12}$ |
| 2.   Zn$^+$ | 20 - 100 | $10^{11}$ - $10^{12}$ |
| 3.   Be$^+$ | 2 - 10 | $10^{11}$ - $10^{12}$ |
| 4.   Cd$^+$ | 40 - 100 | $10^{11}$ - $10^{12}$ |

The ion-implantation can be performed before or after the heat treatment for reducing the dislocation density. In the former case, after the epitaxial growth of the first GaAs layer 3, the p-type impurities are ion-implanted into the whole layer 3 under the above-mentioned conditions, and then the above-mentioned thermal cycle treatment is performed. Since the thermal cycle treatment includes the high temperature heating of 800°C, this treatment serves as the heat treatment for reducing the dislocation density and as the annealing process for recovering the ion-implanted portion and activating the implanted p-type impurities.

In the latter case (after the heat treatment for reducing the dislocation density and the ion-implantation treatment), the annealing is performed in the following three ways. First, a $SiO_2$ cap layer is formed on the whole surface of the first GaAs layer 3, to prevent an evaporation of the V group element (As), the Si substrate temperature is raised to 800°C for, e.g., 90 minutes, under a $H_2$ atmosphere in the growing reactor, to carry out the annealing, and then the SiO$_2$ cap layer is removed by a suitable etching method. Thereafter, the second epitaxial GaAs layer 4 is grown on the first GaAs layer 3 in the above-mentioned manner. Next, the Si substrate with the ion-implanted GaAs layer 3 is reset in the reactor and is heated at 800°C in an AsH$_3$ gas atmosphere for, e.g., 90 minutes, to carry out the annealing process, and thereafter, the second epitaxial GaAs layer 4 is the first GaAs layer 3 in the above-mentioned manner. Finally, the Si substrate with the ion-implanted GaAs layer 3 is reset in the growing furnace and the second epitaxial GaAs layer 4 is grown on the first GaAs layer 3 in the above-mentioned manner, except that the growing temperature is 800°C or more, to carry out the annealing process.

Using the obtained gaAs/Si substrate, a GaAs FET (field effect transistor) is produced in the following manner, as shown in Figs. 5a to 5d.

First, as shown in Fig. 5a, the second epitaxial GaAs layer 4 is covered with a pattern masking layer 8 and is ion-implanted with n-type impurities (e.g., Si) with an energy of 50 keV at a dose of 2 x 10$^{12}$ cm$^{-2}$, to form an n$^-$-type region 9.

Then, as shown in Fig. 5b, the same portion of the second epitaxial GaAs layer 4 is also ion-implanted with p-type impurities (e.g., Mg) with an energy of 80 keV at a dose of 10$^{13}$ cm$^{-2}$, to form a p$^+$-type region 10 under the region 9, and after the masking layer 8 is removed, a gate electrode 11 made of WSi is formed on the region 9 of the layer 4.

Next, as shown in Fig. 5c, the second epitaxial GaAs layer 4 is covered with another pattern masking layer 12 and is further ion-implanted with n-type impurities (e.g., Si), with an energy of 150 keV at a dose of 2 x 10$^{13}$ cm$^{-2}$, to form n$^+$-type source and drain regions 14 and 15, and after the masking layer 12 is removed, the GaAs/Si substrate is annealed at a temperature of 800°C or more to recover the ion-implanted portion of the layer 4 and to activated the implanted impurities.

Finally, as shown in Fig. 5d, a source electrode 16 and a drain electrode 17, made of AuGe/Au, are formed on the regions 14 and 15, respectively, to obtain the GaAs FET.

Instead of the GaAs FET, a GaAs laser can be produced by using the GaAs/Si substrate according to the present invention.

## Claims

1. A method of forming a compound semiconductor layer hetero-epitaxially grown on a silicon single crystal substrate comprising the steps of:
   growing a first compound semiconductor layer (3) on said silicon substrate (1);
   heat treating said substrate (1); and
   growing a second compound semiconductor layer (4) on said first compound semiconductor layer characterised by doping the interface between the first compound semiconductor layer (3) and second compound semiconductor layer (4) with a p-type impurity prior to or during the step of growing the second compound layer (4).

2. A method according to claim 1, further comprising a step of growing an amorphous compound semiconductor layer (2) prior to said step of growing the first compound semiconductor layer (3).

3. A method according to claim 2, wherein said heat treatment step is performed by at least one cycle of heating said substrate (1) to a temperature higher than a temperature used in said step for growing the first compound semiconductor layer (3) and cooling said substrate to a temperature lower than said temperature used in said growing step.

4. A method according to claim 1, wherein said heat treatment step is performed by heating said substrate (1) at a constant temperature higher than temperature used in said step for growing the first compound semiconductor layer (3).

5. A method according to any one of the preceding claims, wherein said compound semiconductor layer (3,4) is a compound selected from the group consisting of a III-V group compound, a II-VI group compound, and a IV-VI group compound.

6. A method according to claim 5, wherein said III-V group compound semiconductor layer is a compound selected from the group consisting of GaAs, AlAs, GaP, and InAs.

7.    A method according to claim 6, wherein said III-V group compound semiconductor layer is GaAs.

8.    A method according to any one of the preceding claims, wherein said p-type impurities are an element selected from the group consisting of Zn, Be, C, and Mg.

9.    A method according to any one of the preceding claims, wherein in said second compound semiconductor layer (4) an electronic device is formed.

10.   A method according to any one of the preceding claims, wherein said p-type impurities are doped, to thereby compensate for electron carriers by carrying out the step of heat treating in an atmosphere including a volatile group element of said compound semiconductor and a p-type impurity.

11.   A method according to any one of claims 1 to 9, in which the p-type impurities are doped by ion-implanting p-type impurities into said first compound semiconductor layer (3).

12.   A method according to claim 11, wherein said ion-implanting step is performed, and then said heat treating step is performed for reducing a dislocation density.

13.   A method according to claim 11, wherein said heat treating step is performed for reducing a dislocation density, and then said ion-implanting step is performed.

14.   A method according to claim 13, wherein said annealing step is performed by forming a $SiO_2$ cap layer on said first compound semiconductor layer, holding said substrate at a temperature higher than a temperature used in said step for growing the first compound semiconductor layer, and removing said cap layer.

15.   A method according to claim 13, wherein said annealing step is performed by holding said substrate at a temperature of 800°C or more under an atmosphere containing a volatile group element of said compound semiconductor.

16.   A method according to claim 13, wherein said annealing step is performed during said step for growing the second compound semiconductor layer, at a temperature of 800°C or more.

17.   A method of producing a semiconductor device in a compound semiconductor layer hetero-epitaxially grown on a silicon single crystal substrate, comprising the steps of:
      growing a first compound semiconductor layer(3) on said silicon substrate (1);
      heat treating said substrate and said layer(3) to reduce a dislocation density thereof;
      growing a second compound semiconductor layer (4) on said first compound semiconductor layer(3);
      doping the interface between said first compound semiconductor layer (3) and said second compound semiconductor layer with p-type impurities prior to or during the step of growing the second compound layer (4) to thereby compensate for electron carriers;
      doping said second compound semiconductor layer (4) with impurities to form at least one impurity-introduced region (9, 10, 14, 15);
      forming an electrode (11, 16, 17) on said impurity-introduced region of said second compound semiconductor layer (4).


**Patentansprüche**

1.    Ein Verfahren zum Bilden einer heteroepitaxial gewachsenen Verbindungshalbleiterschicht auf einem Silizium-Einkristallsubstrat, mit den Schritten:
      Wachsen einer ersten Verbindungshalbleiterschicht (3) auf dem genannten Siliziumsubstrat (1);
      Wärmebehandlung des genannten Substrates (1); und
      Wachsen einer zweiten Verbindungshalbleiterschicht (4) auf der genannten ersten Verbindungshalbleiterschicht, gekennzeichnet durch Dotieren des Grenzbereiches zwischen der ersten Verbindungshalbleiterschicht (3) und der zweiten Verbindungshalbleiterschicht (4) mit einer p-Typ-Verunreinigung vor dem oder während des Schrittes des Wachsens der zweiten Verbindungsschicht (4).

**2.** Ein Verfahren nach Anspruch 1, ferner mit einem Schritt des Wachsens einer amorphen Verbindungshalbleiterschicht (2) vor dem genannten Schritt des Wachsens der ersten Verbindungshalbleiterschicht (3).

**3.** Ein Verfahren nach Anspruch 2, bei dem der genannte Wärmebehandlungsschritt ausgeführt wird durch wenigstens einen Zyklus des Erhitzens des genannten Substrates (1) auf eine Temperatur, die höher als eine Temperatur ist, die bei dem genannten Schritt zum Wachsen der ersten Verbindungshalbleiterschicht (3) verwendet wird, und des Abkühlens des genannten Substrates auf eine Temperatur, die niedriger als die genannte Temperatur ist, die bei dem genannten Schritt des Wachsens verwendet wird.

**4.** Ein Verfahren nach Anspruch 1, bei dem der genannte Wärmebehandlungsschritt ausgeführt wird, indem das genannte Substrat (1) bei einer konstanten Temperatur erhitzt wird, die höher als die Temperatur ist, die bei dem genannten Schritt zum Wachsen der ersten Verbindungshalbleiterschicht (3) verwendet wird.

**5.** Ein Verfahren nach irgendeinem der vorhergehenden Ansprüche, bei dem die genannte Verbindungshalbleiterschicht (3, 4) eine Verbindung ist, die ausgewählt ist aus der Gruppe bestehend aus einer Verbindung der Gruppe III-V, einer Verbindung der Grupper II-VI und einer Verbindung der Gruppen IV-VI.

**6.** Ein Verfahren nach Anspruch 5, bei dem die genannte Verbindungshalbleiterschicht der Gruppe III-V eine Verbindung ist, die ausgewählt ist aus der Gruppe bestehend aus GaAs, AlAs, GaP und InAs.

**7.** Ein Verfahren nach Anspruch 6, bei dem die genannte Verbindungshalbleiterschicht der Gruppe III-V GaAs ist.

**8.** Ein Verfahren nach irgendeinem der vorhergehenden Ansprüche, bei dem die genannten p-Typ-Verunreinigungen ein Element sind, das ausgewählt ist aus der Gruppe bestehend aus Zn, Be, C und Mg.

**9.** Ein Verfahren nach irgendeinem der vorhergehenden Ansprüche, bei dem in der genannten zweiten Verbindungshalbleiterschicht (4) eine elektronische Vorrichtung gebildet wird.

**10.** Ein Verfahren nach irgendeinem der vorhergehenden Ansprüche, bei dem die genannten p-Typ-Verunreinigungen dotiert werden, um dadurch Elektronenträger zu kompensieren, indem der Schritt der Wärmebehandlung in einer Atmosphäre ausgeführt wird, die ein flüchtiges Gruppenelement des genannten Verbindungshalbleiters und eine p-Typ-Verunreinigung enthält.

**11.** Ein Verfahren nach irgendeinem der Ansprüche 1 bis 9, bei dem die p-Typ-Verunreinigungen dotiert werden durch
Ionenimplantation von p-Typ-Verunreinigungen in die genannte erste Verbindungshalbleiterschicht (3).

**12.** Ein Verfahren nach Anspruch 11, bei dem der genannte Ionenimplantationsschritt ausgeführt wird und dann der genannte Wärmebehandlungsschritt zum Reduzieren einer Dislokationsdichte ausgeführt wird.

**13.** Ein Verfahren nach Anspruch 11, bei dem der genannte Wärmebehandlungsschritt zum Reduzieren einer Dislokationsdichte ausgeführt wird und dann der genannte Ionenimplantationsschritt ausgeführt wird.

**14.** Ein Verfahren nach Anspruch 13, bei dem der genannte Annealschritt ausgeführt wird, indem eine SiO$_2$-Kappenschicht auf der genannten ersten Verbindungshalbleiterschicht gebildet wird, das genannte Substrat auf einer Temperatur gehalten wird, die höher ist als eine Temperatur, die bei dem genannten Schritt zum Wachsen der ersten Verbindungshalbleiterschicht verwendet wird, und die genannte Kappenschicht entfernt wird.

**15.** Ein Verfahren nach Anspruch 13, bei dem der genannte Annealschritt ausgeführt wird, indem das genannte Substrat in einer Atmosphäre, die ein flüchtiges Gruppenelement des genannten Verbindungshalbleiters enthält, auf einer Temperatur von 800°C oder mehr gehalten wird.

**16.** Ein Verfahren nach Anspruch 13, bei dem der genannte Annealschritt während des genannten Schrittes zum Wachsen der zweiten Verbindungshalbleiterschicht bei einer Temperatur von 800°C oder mehr ausgeführt wird.

17. Ein Verfahren zum Herstellen einer Halbleitervorrichtung in einer Verbindungshalbleiterschicht, die auf einem Silizium-Einkristallsubstrat heteroepitaxial gewachsen ist, mit den Schritten:

Wachsen einer ersten Verbindungshalbleiterschicht (3) auf dem genannten Siliziumsubstrat (1);

Wärmebehandlung des genannten Substrates und der genannten Schicht (3), um deren Dislokationsdichte und reduzieren;

Wachsen einer zweiten Verbindungshalbleiterschicht (4) auf der genannten Verbindungshalbleiterschicht (3);

Dotieren des Grenzbereiches zwischen der genannten ersten Verbindungshalbleiterschicht (3) und der genannten zweiten Verbindungchalbleiterschicht mit p-Typ-Verunreinigungen vor dem oder während des Schrittes des Wachsens der zweiten Verbindungsichicht (4), um dadurch Elektronenträger zu kompensieren;

Dotieren der genannten zweiten Verbindungshalbleiterschicht (4) mit Verunreinigungen, um wenigstens eine verunreinigungshaltige Zone (9, 10, 14, 15) zu bilden;

Bilden einer Elektrode (11, 16, 17) auf der genannten verunreinigungshaltigen Zone der genannten zweiten Verbindungshalbleiterschicht (4).

## Revendications

1. Procédé de formation d'une couche de semiconducteur composé par croissance hétéroépitaxiale sur un substrat monocristallin de silicium comprenant les étapes suivantes :

on fait croître une première couche de semiconducteur composé (3) sur ledit substrat de silicium (1) ;

on traite ledit substrat (1) par la chaleur ; et

on fait croître une seconde couche de semiconducteur composé (4) sur ladite première couche de semiconducteur composé,

caractérisé en ce que l'on dope l'interface entre la première couche de semiconducteur composé (3) et la seconde couche de semiconducteur composé (4) avec une impureté du type p avant ou pendant l'étape de croissance de la seconde couche de semiconducteur composé (4).

2. Procédé selon la revendication 1, comprenant en outre une étape de croissance d'une couche de semiconducteur composé amorphe (2) avant ladite étape de croissance de la première couche de semiconducteur composé (3).

3. Procédé selon la revendication 2, dans lequel ladite étape de traitement thermique est effectuée par au moins un cycle de chauffage dudit substrat (1) à une température supérieure à la température utilisée dans ladite étape pour la croissance de la première couche de semiconducteur composé (3) et de refroidissement dudit substrat à une température inférieure à ladite température utilisée dans ladite étape de croissance.

4. Procédé selon la revendication 1, dans lequel ladite étape de traitement thermique est effectuée en chauffant ledit substrat (1) à une température constante supérieure à la température utilisée dans ladite étape pour la croissance de la première couche de semiconducteur composé (3).

5. Procédé selon l'une quelconque des revendications précédentes, dans lequel ladite couche de semiconducteur composé (3, 4) est un composé choisi parmi un composé des groupes III-V, un composé des groupes II-VI et un composé des groupes IV-VI.

6. Procédé selon la revendication 5, dans lequel ladite couche de semiconducteur composé des groupes III-V est un composé choisi parmi GaAs, AlAs, GaP et InAs.

7. Procédé selon la revendication 6, dans lequel ladite couche de semiconducteur composé des groupes III-V est GaAs.

8. Procédé selon l'une quelconque des revendications précédentes, dans lequel l'impureté de type p est un élément choisi parmi Zn, Be, C et Mg.

9. Procédé selon l'une quelconque des revendications précédentes, dans lequel on forme un dispositif électronique dans ladite seconde couche de semiconducteur composé (4).

10. Procédé selon l'une quelconque des revendications précédentes, dans lequel on introduit ladite impureté de dopage de type p pour compenser ainsi les porteurs, les électrons, en mettant en oeuvre l'étape de traitement thermique dans une atmosphère contenant un élément du groupe volatil dudit semiconducteur composé et une impureté de type p.

11. Procédé selon l'une quelconque des revendications 1 à 9, dans lequel on introduit l'impureté de dopage de type p par implantation ionique d'impuretés de type p dans ladite première couche de semiconducteur composé (3).

12. Procédé selon la revendication 11, dans lequel on effectue ladite étape d'implantation ionique et ensuite on effectue ladite étape de traitement thermique pour réduire la densité de dislocations.

13. Procédé selon la revendication 11, dans lequel on effectue ladite étape de traitement thermique pour réduire la densité de dislocations et ensuite on effectue ladite étape d'implantation ionique.

14. Procédé selon la revendication 13, dans lequel on effectue ladite étape de recuit en formant une couche de capot de $SiO_2$ sur ladite première couche de semiconducteur composé, en maintenant ledit substrat à une température supérieure à la température utilisée dans ladite étape pour la croissance de la première couche de semiconducteur composé et en éliminant ladite couche de capot.

15. Procédé selon la revendication 13, dans lequel on effectue ladite étape de recuit en maintenant ledit substrat à une température de 800°C ou plus dans une atmosphère contenant un élément du groupe volatil dudit semiconducteur composé.

16. Procédé selon la revendication 13, dans lequel on effectue ladite étape de recuit pendant ladite étape pour la croissance de la seconde couche de semiconducteur composé à une température de 800°C ou plus.

17. Procédé de production d'un dispositif semiconducteur dans une couche de semiconducteur composé produite par croissance hétéroépitaxiale sur un substrat monocristallin de silicium, comprenant les étapes suivantes :

on fait croître une première couche de semiconducteur composé (3) sur ledit substrat de silicium (1) ;

on traite ledit substrat par la chaleur et ladite couche (3) pour réduire sa densité de dislocations ;

on fait croître une seconde couche de semiconducteur composé (4) sur ladite première couche de semiconducteur composé (3) ;

on dope l'interface entre ladite première couche de semiconducteur composé (3) et ladite seconde couche de semiconducteur composé (4) avec une impureté du type p avant ou pendant l'étape de croissance de la seconde couche de semiconducteur composé (4) ;

on dope ladite seconde couche de semiconducteur composé (4) avec une impureté pour former au moins une région dopée par l'impureté (9, 10, 14, 15) ;

on forme une électrode (11, 16, 17) sur ladite région de ladite seconde couche de semiconducteur (4) dopée par l'impureté.

Fig.1a

Fig.1b

Fig.1c

Fig.1d

10

# Fig. 2

# Fig. 3

# Fig. 4

Fig. 5a

Fig. 5b

Fig. 5C

Fig. 5d